(19) Europäisches Patentamt
European Patent Office
Office européen des brevets

(11) Publication number: 0 556 429 A1

(12) # EUROPEAN PATENT APPLICATION

(21) Application number: 92102764.5

(51) Int. Cl.5: C08G 59/06, C08J 5/24

(22) Date of filing: 19.02.92

(43) Date of publication of application: 25.08.93 Bulletin 93/34

(84) Designated Contracting States: AT BE CH DE ES FR GB IT LI NL SE

(71) Applicant: THE DOW CHEMICAL COMPANY
2030 Dow Center, Abbott Road
Midland, MI 48640(US)

(72) Inventor: Ohnishi, Hideyuki
1480 Niihashi
Gotemba-shi, Shizuoka-ken 412(JP)
Inventor: Kishino, Yasuhiko
2-4-14 Tokura
Mishima-shi, Shizuoka-ken 411(JP)

(74) Representative: Casalonga, Axel et al
BUREAU D.A. CASALONGA - JOSSE
Morassistrasse 8
D-80469 München (DE)

(54) **Epoxy resin compositions.**

(57) An epoxy resin composition comprising:
(A) a dicyclopentadiene-novolac epoxy resin represented by the following formula (I):

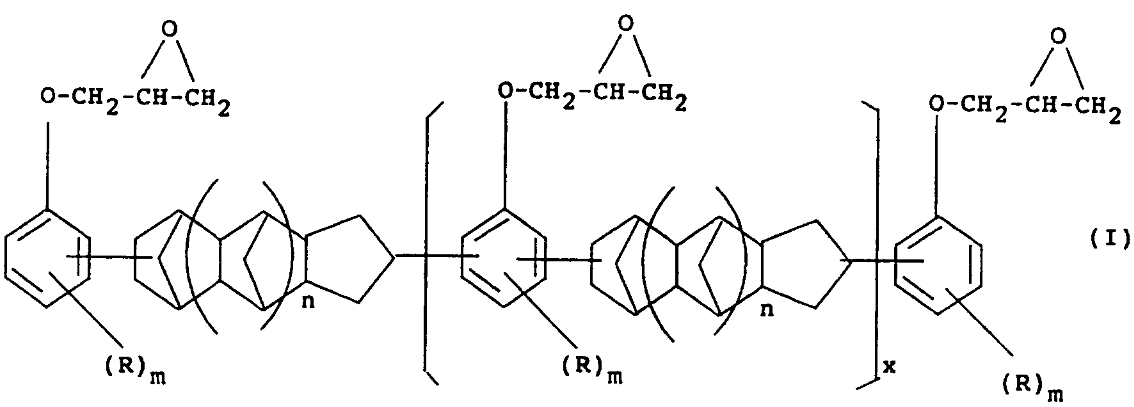

(I)

wherein each R is independently a hydrogen atom, an alkyl group having 1 to 3 carbon atoms or a halogen group; n is a number of from 0 to 2; m is a number of from 0 to 4; and x is a number of from 0 to 6; and
(B) at least one phenolic hydroxyl-containing compound. A laminating varnish comprising the above resin composition, an electrical laminate prepared therefrom and a process for preparation of electrical laminates, are also disclosed.

EP 0 556 429 A1

The present invention relates to a novel resin composition which has good workability and exhibits, when cured, good heat resistance, good moisture resistance and excellent electrical properties. The present invention also relates to a laminating varnish comprising the above composition, an electrical laminate prepared therefrom and a process for preparation of electrical laminates.

Epoxy resins have been widely used in electrical or electronics fields because of their good electrical properties and good mechanical properties. However, it has been desired to provide epoxy resins having further improved properties in view of severe requirements due to the recent need to make highly dense and highly precise electrical parts.

Heretofore, in preparation of printed circuit boards, brominated epoxy resins having an epoxy equivalent weight (EEW) of 400 to 550 and a bromine content of 18 to 25 percent, have been employed. Such brominated epoxy resins have been prepared by reacting an epoxy resin such as a liquid epoxy resin and a dihydric phenol such as bisphenol A or tetrabromobisphenol A. In this system, the final cured products can be obtained by curing the brominated resins with an amine curing agent such as dicyandiamide and a small amount of a catalyst such as 2-ethyl-4-methylimidazole (2E4MI) or 2-methylimidazole (2MI).

Further, to improve heat resistance, a multifunctional epoxy resin such as an epoxy novolac resin is added to the brominated epoxy resins. However, such epoxy resin compositions comprising a brominated epoxy resin and a multifunctional epoxy resin may suffer gelation during the reaction. Also, such epoxy resin compositions do not exhibit, when cured, well-balanced physical properties and sometimes the curing of the compositions is not sufficient.

In view of the deficiencies of the above-mentioned prior art, it would be desirable to provide an epoxy resin composition which has good workability and exhibits, when cured, good heat resistance, good moisture resistance and excellent electrical properties.

One aspect of the present invention pertains to an epoxy resin composition comprising:

(A) a dicyclopentadiene-novolac epoxy resin represented by the following formula (I):

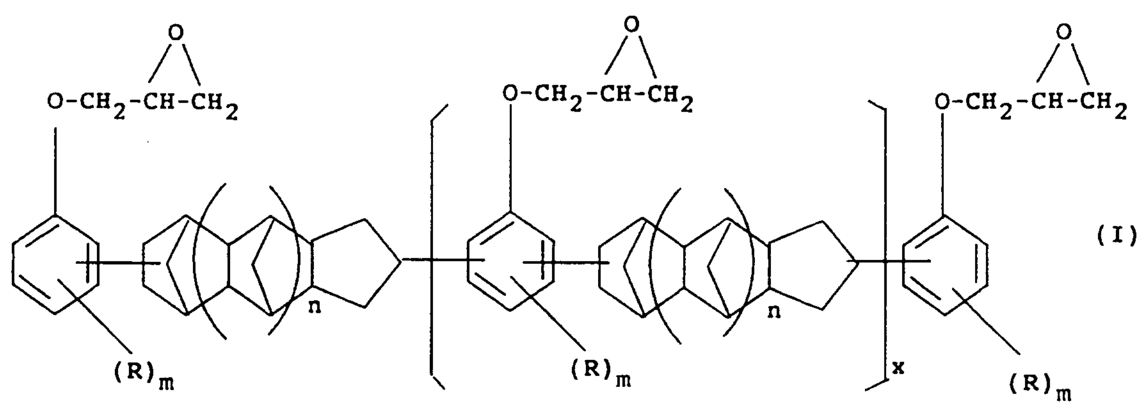

(I)

wherein each R is independently a hydrogen atom, an alkyl group having from 1 to 3 carbon atoms or a halogen group; n is a number of from 0 to 2; m is a number of from 0 to 4; and x is a number of from 0 to 6, suitably from 0 to 2; and

(B) at least one phenolic hydroxyl-containing compound; and optionally,

(C) an epoxy-containing component, which is different from Component (A), selected from (C-1) an epoxy resin having an average of not more than 2 vicinal epoxy groups, (C-2) an epoxy resin having an average of more than 2 vicinal epoxy groups, and (C-3) a combination of Component (C-1) and Component (C-2).

Another aspect of the present invention pertains to a a laminating varnish comprising the above-mentioned resin composition, and at least one solvent.

A further aspect of the present invention pertains to an electrical laminate resulting from curing one or more plies of a substrate material which has been impregnated with the above-mentioned laminating varnish.

A still further aspect of the present invention pertains to a process for preparing an electrical laminate which comprises the steps of (a) impregnating a substrate with the above-mentioned curable composition; (b) heating the thus prepared prepreg; (c) fabricating the prepreg into an electrical laminate by laminating one or more layers of the prepreg with an electrical conductive material; and (d) heating the thus prepared laminate at elevated temperature and pressure.

The cured products of the above-mentioned resin compositions have good heat resistance since they contain a dicyclopentadiene structure in the main chains of the molecules. The cured products also exhibit good moisture resistance and excellent electrical properties because of extremely low polarity of the dicyclopentadiene structure. Also, the dicyclopentadiene structure functions to reduce inner stress of the cured products, leading to good mechanical properties for electrical or electronics application (e.g., electrical laminates).

The epoxy resin compositions can be prepared by blending the components together in any suitable manner such as, for example, mixing the two epoxy resins together in a solvent at elevated temperatures to form a uniform mixture, then cooling to room temperature and blending in the two phenolic compounds to form a uniform mixture.

The dicyclopentadiene-novolac epoxy resins (hereinafter referred to as "DCPD epoxy resin") which can be used in the present invention, Component (A), are represented by the following formula (I):

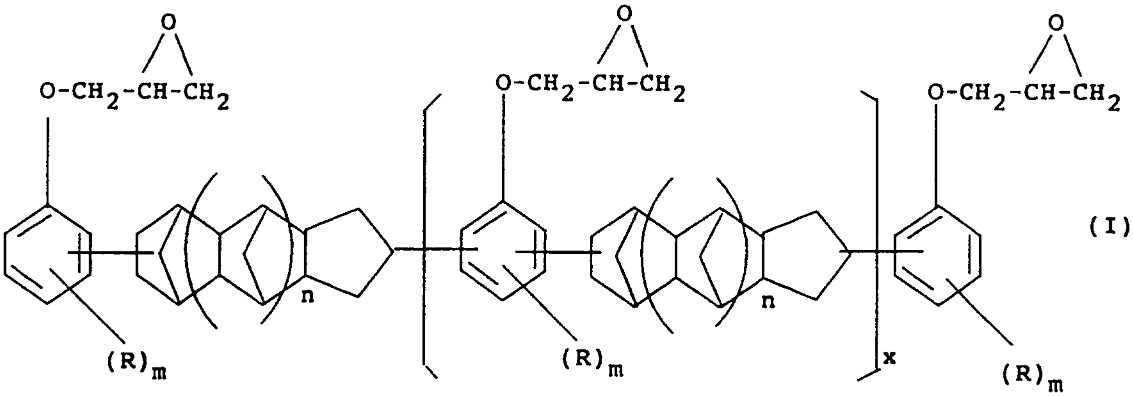

(I)

wherein each R is independently a hydrogen atom, an alkyl group having from 1 to 3 carbon atoms or a halogen group; n is a number of from 0 to 2; m is a number of from 0 to 4; and x is a number of from 0 to 6, suitably from 0 to 2. The DCPD epoxy resins are described in, for example, U.S. Patents Nos. 3,536,734 and 4,764,571, and European Patent Application No. 148817A.

Suitable DCPD epoxy resins which can be used in the present invention are those having an epoxy equivalent weight of from 200 to 400, more suitably from 210 to 280.

As Component (B), any phenolic hydroxyl-containing compounds can be used, which include phenolic hydroxyl-containing compounds having an average of more than 1 but not more than 2 phenolic hydroxyl groups per molecule; and phenolic hydroxyl-containing compounds having an average of more than 2 phenolic hydroxyl groups per molecule. In the present invention, Component (B) is used to advance the DCPD epoxy resins, Component (A).

Phenolic hydroxyl-containing compounds having an average of more than 1 but not more than 2 phenolic hydroxyl groups per molecule (Component (B)) include, for example, those represented by the following formulas (II) and (III):

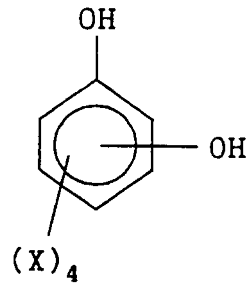

(II)

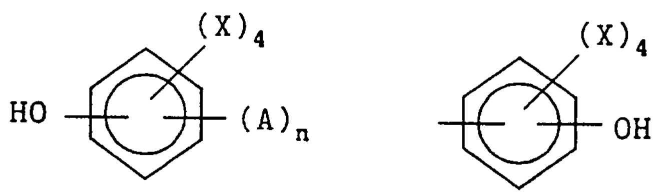

(III)

wherein each A is independently a divalent hydrocarbyl group having suitably from 1 to 10, more suitably from 1 to 5, most suitably from 1 to 3, carbon atoms, -S-, -S-S-, -SO-, -SO2-, -CO-, or -O-; each X is independently hydrogen, an alkyl group having suitably from 1 to 10, more suitably from 1 to 5, most suitably from 1 to 3, carbon atoms or a halogen, preferably chlorine or bromine: n has a value of from zero or 1.

The term "hydrocarbyl" as employed herein means any aliphatic, cycloaliphatic, aromatic, aryl substituted aliphatic or cycloaliphatic, or aliphatic or cycloaliphatic substituted aromatic groups.

Suitable phenolic hydroxyl-containing compounds having an average of more than 1 but not more than 2 phenolic hydroxyl groups per molecule include, for example, bisphenol A, bisphenol K, bisphenol F, bisphenol S, bisphenol AD, the halogenated, particularly the brominated, derivatives of the afore-mentioned bisphenols wherein the halogen atoms are either ortho- or meta- with respect to the ether oxygen atoms, resorcinol, catechol, hydroquinone, tetramethylbisphenol A, 4,4'-dihydroxybiphenyl, 3,5,3'5'-tetramethyl-4,4'-dihydroxybiphenyl, 3,5,3'5'-tetrabromodihydroxybiphenyl, 3,5,3'5'-tetramethyl-2,6,2',6'-tetrabromo-4,4'-dihydroxybiphenyl and any combination thereof. The most preferred compound is tetrabromobisphenol A.

Suitable phenolic hydroxyl-containing component having an average of more than 2 phenolic hydroxyl groups per molecule (Component (B)) include, for example, those represented by the following formulas (IV) and (V):

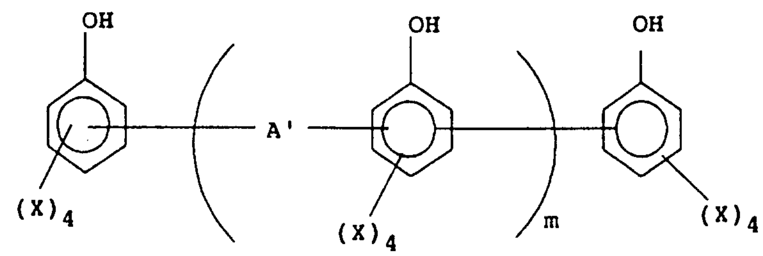

(IV)

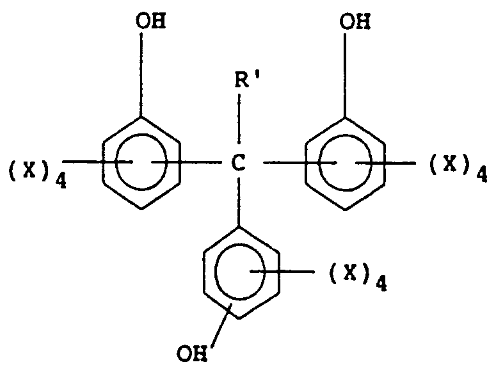

(V)

wherein each X is as previously defined; each A' is independently a divalent hydrocarbyl group suitably having from 1 to 10, more suitably from 1 to 4, most suitably from 1 to 2, carbon atoms or a divalent polycylopentadiene group; R' is hydrogen or a hydrocarbyl group having suitably from 1 to 10, more suitably from 1 to 5, most suitably from 1 to 2, carbon atoms; m suitably has a value from 0.1 to 7, more suitably from 1 to 5, most suitably from 1 to 4.

Particularly suitable phenolic hydroxyl-containing compounds having an average of more than 2 phenolic hydroxyl groups per molecule include, for example, phenol-formaldehyde novolac resins, cresol-formaldehyde novolac resins, brominated phenol-formaldehyde novolac resins, brominated cresol-formaldehyde novolac resins, 3,3',5,5'-tetramethyl-(1,1',-biphenyl)-2,4,4'-triol, pyrogallol and any combination thereof.

In the practice of the present invention, in addition to the above Component (A) and Component (B), an epoxy-containing component, which is different from Component (A), can be added as Component (C). The epoxy-containing component, Component (C), can be selected from (C-1) an epoxy resin having an average of not more than 2 vicinal epoxy groups, (C-2) an epoxy resin having an average of more than 2 vicinal epoxy groups, and (C-3) a combination of Component (C-1) and Component (C-2).

Suitable epoxy resins having an average of not greater than two vicinal epoxy groups per molecule (Component (C-1) are, for example, those diglycidyl ethers of dihydric phenols represented by the formulas (VI) and (VII):

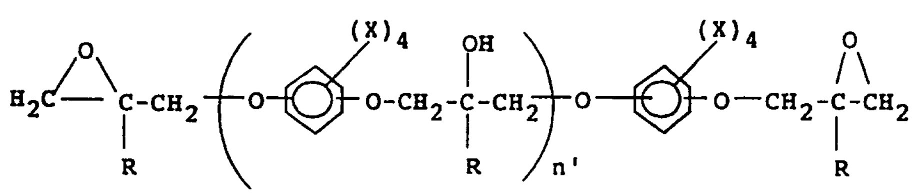

(VI)

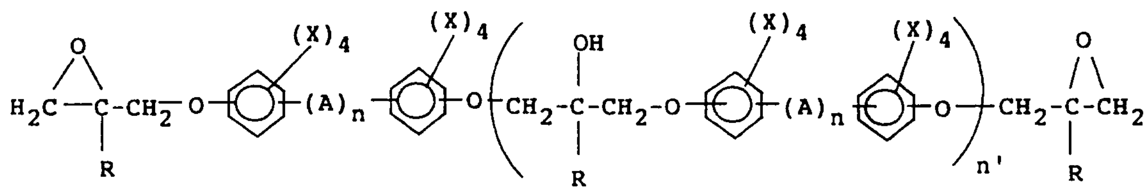

(VII)

wherein each A and each X are as previously defined; each R is independently hydrogen or an alkyl group having from 1 to 3 carbon atoms; and n' has a value suitably from zero to 10, more suitably from zero to 2, most suitably from zero to 0.5.

Particularly suitable epoxy resins having an average of more than 1 but not more than 2 vicinal epoxy groups per molecule include, for example, the diglycidyl ethers of bisphenol A, tetrabromobisphenol A where the bromine atoms are in the ortho- or meta- positions relative to the ether oxygen atoms, bisphenol K, bisphenol F, bisphenol S, bisphenol AD and mixtures thereof.

Suitable epoxy resins having an average of more than 2 vicinal epoxy groups per molecule (Component (C-2)) include, for example, those represented by the formulas (VIII) and (IX):

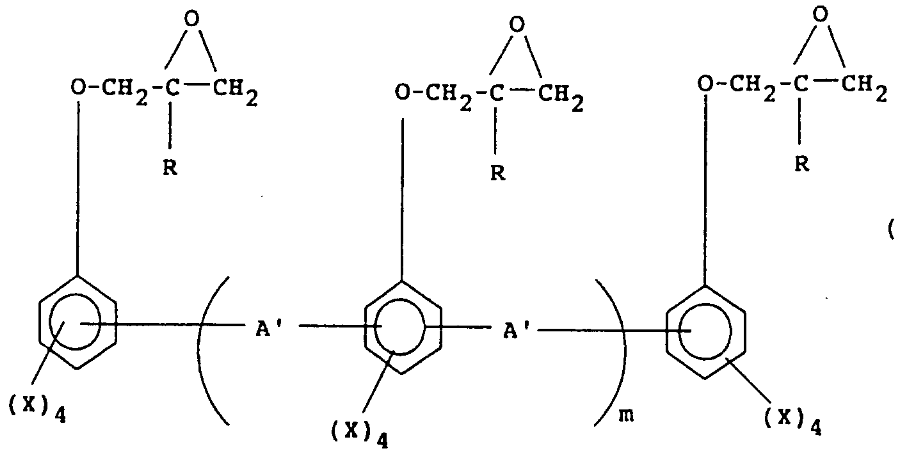

(VIII)

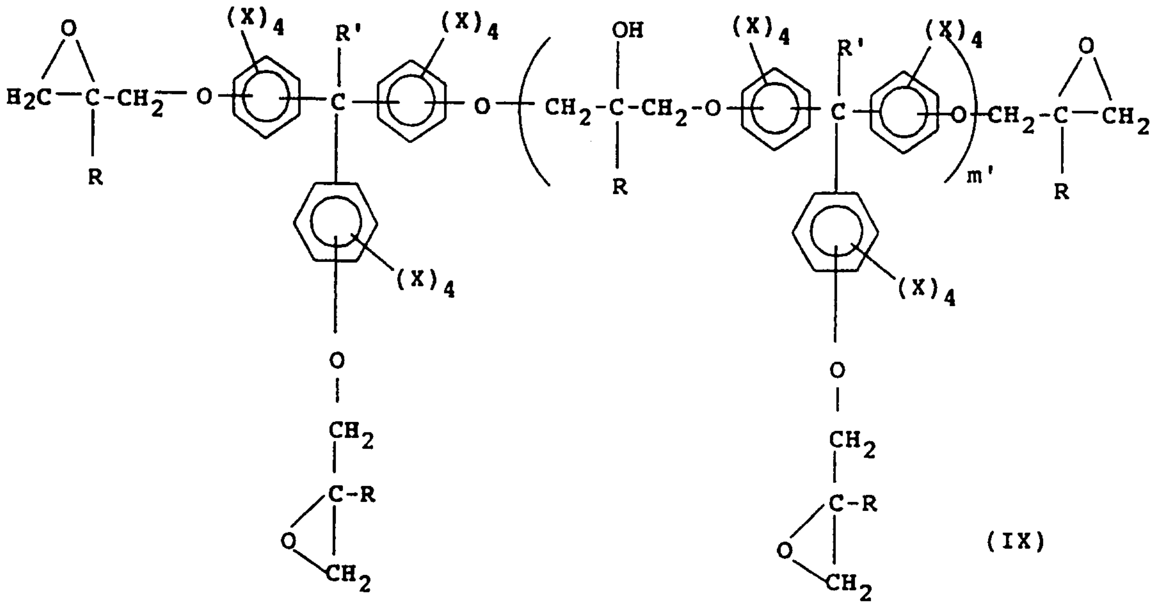

(IX)

wherein each A', X, R, R' and m are as described above; and m' suitably has a value from zero to 3, more suitably from zero to 2, most suitably from zero to 1.

Suitable epoxy resins having an average of more than 2 phenolic hydroxyl groups include a phenol-formaldehyde novolac epoxy resin, cresol-formaldehyde novolac epoxy resin, brominated phenol-formaldehyde novolac epoxy resin, brominated cresol-formaldehyde novolac epoxy resin, glycidylethers of trispenols and a mixture thereof.

In the present invention, an epoxy component (Component (A) alone; or Components (A) and Components (C-1) and/or (C-2)) and a phenolic hydroxyl component (Component (B)) may be used to provide an epoxy component to phenolic hydroxyl component ratio by weight of from 60:40 to 80:20, more suitably from 65:35 to 75:25. Preferably, Component (A) may be used in amounts of from 1 to 70 percent by weight, more suitably from 40 to 70 percent by weight, based on the total weight of the epoxy component. These component ratios are determined in view of the properties of the target products. With increase in the amount of Component (A) used, the final cured products will have increased heat resistance, but the workability will be decreased.

In the practice of the present invention, a novel epoxy resin can be obtained by subjecting Components (A) and (B) to an advancement reaction. The obtained, advanced epoxy resins suitably have an epoxy equivalent weight of from 200 to 1,000, more suitably from 300 to 600, most suitably from 350 to 450.

In the case of using the resin compositions for preparation of electric circuit boards requiring flame retardancy, the bromine content of the final cured product may be adjusted to be within a range of from 10 to 60, more suitably from 15 to 40, most suitably from 15 to 25 percent by weight.

Suitable catalysts for effecting the reaction between the epoxy resin and the phenolic hydroxyl-containing compound include, for example, those disclosed in U.S. Patent Nos. 3,306,872; 3,341,580; 3,379,684; 3,477,990; 3,547,881; 3,637,590; 3,843,605; 3,948,855; 3,956,237; 4,048,141; 4,093,650; 4,131,633; 4,132,706; 4,171,420; 4,177,216; 4,302,574; 4,320,222; 4,358,578; 4,366,295; and 4,389,520.

Particularly suitable catalysts are those quaternary phosphonium and ammonium compounds such as, for example, ethyltriphenylphosphonium chloride, ethyltriphenylphosphonium bromide, ethyltriphenylphosphonium iodide, ethyltriphenylphosphonium acetate, ethyltriphenylphosphonium diacetate (ethyltriphenylphosphonium acetate.acetic acid complex), ethyltriphenylphosphonium tetrahaloborate, tetrabutylphosphonium chloride, tetrabutylphosphonium bromide, tetrabutylphosphonium iodide, tetrabutylphosphonium acetate, tetrabutylphosphonium diacetate (tetrabutylphosphonium acetate•acetic acid complex), tetrabutylphosphonium tetraholoborate•butyltriphenylphosphonium tetrabromobisphenate, butyltriphenylphosphonium bisphenate, butyltriphenylphosphonium bicarbonate, benzyltrimethylammonium chloride, benzyltrimethylammonium hydroxide, benzyltrimethylammonium tetrahaloborate, tetramethylammonium hydroxide, tetrabutylammonium hydroxide, tetrabutylammonium tetraholoborate and mixtures thereof.

Other suitable catalysts include, for example, tertiary amines such as triethylamine, tripropylamine, tributylamine and benzyldimethylamine, imidazoles such as 2-methylimidazole and mixtures thereof.

Other suitable catalysts include, for example, ammonium compounds such as triethylamine•HCl complex, triethylamine•HBr complex, triethylamine•HI complex, triethylamine•terahaloboric acid complex, tributylamine•HCl complex, tributylamine•HBr complex, tributylamine•HI complex, tributylamine•tetrahaloboric acid complex, N,N'-dimethyl-1,2-diaminoethane•tetrahaloboric acid complex and mixtures thereof.

Other suitable catalysts include quaternary and tertiary ammonium phosphonium, and arsonium adducts or complexes with suitable non-nucleophilic acids such as fluoboric, fluoarsenic, fluoantimonic, fluophosphoric, perchloric, perbromic, periodic acid and mixtures thereof.

The catalysts are employed in any quantity which will promote the reaction between the phenolic hydroxyl-containing compound and the epoxy-containing compound. Usually, a suitable quantity of catalyst is from 0.001 to 10, more suitably from 0.05 to 5 percent by weight of the total weight of the reaction mixture.

Suitable curing agents which can be used in the present invention include, for example, tertiary amines, dicarboxylic anhydrides, diguanide, sulfoneamide, amides, sulfonates, polyhydrophenols, guanazine, novolac resins and mixtures thereof.

Particularly suitable curing agents include, for example, bis-(4-aminophenyl)sulfone, aminophenylsulfoneamide, dicyandiamide, a phenol-formaldehyde novolac resin, a cresol-formaldehyde novolac resin, phenylenediamine, methyledianiline, phthalic anhydride and mixtures thereof.

The curing agents may be used in amounts sufficient to cure the resin compositions to prescribed extent, depending upon the kind of the curing agent used and the epoxy resins used, and the desired degree of cure. In the present invention, the curing agents may be used in amounts to provide an epoxy equivalent to active hydrogen equivalent of curing agent of from 1:0.75 to 1:1.1.

If desired, it may be desirable to include in the composition a stabilizer, pigment, dye, mold release agent, flow modifier, reinforcing material, filler, flame retardant, rubber modifier, surfactant, accelerator, reaction diluent and mixtures thereof.

Suitable stabilizers which can be used in the present invention include those represented by the following formula (X):

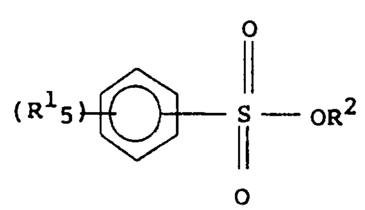

(X)

wherein each $R^1$ is dependently hydrogen, a hydrocarbyl group having from 1 to 10 carbon atoms or halogen; and $R^2$ is a hydrocarbyl group having from 1 to 10 carbon atoms.

Particularly suitable stabilizers include, for example, methyl p-toluene sulfonate, ethyl p-toluene sulfonate, methylchlorobenzene sulfonate and mixtures thereof. The most suitable stabilizer is methyl p-toluene sulfonate.

These stabilizers when employed, are employed in amounts to provide suitable stability, for example, from 0.001 to 10, more suitably from 0.01 to 2 percent by weight based upon the weight of the epoxy-containing component.

Suitable accelerators include the catalysts for effecting the reaction of the epoxy-containing component and the hydroxyl-containing component, as listed before.

Suitable fillers or pigments or flow modifiers include, for example, titanium dioxide, iron oxide, calcium carbonate, quartz, fused silica, silicates, silanes, metal powders such as, for example, aluminum, iron, magnesium and any combination thereof.

The epoxy resin compositions of the present invention can be suitably used for use in preparation of encapsulated electric parts and laminates for printed circuit boards.

In the preparation of laminates from the resin compositions of the present invention, the resin compositions are dissolved into one or more solvents, to obtain a laminating varnish, and applied to the substrate material from which the prepreg is to be prepared, to impregnate the laminating varnish into the substrate material.

Suitable such solvents include, for example, aromatic hydrocarbons, ketones, glycol ethers, alcohols, aliphatic hydrocarbon, cyclic ethers, halogenated hydrocarbons and amides. Particularly suitable solvents include, for example, acetone, methyl ethyl ketone, methanol, ethanol, propylene glycol methyl ether, dimethylformamide and any combination thereof. The amount of solvent which is employed is the quantity which provides the laminating varnish or other curable composition with the desired application viscosity. Usually, an amount of solvent is suitably from 1 to 75 more suitably from 1 to 50, most suitably from 1 to 25 parts by weight based upon the total weight of the laminating varnish.

Suitable substrate materials include natural and synthetic fibrous materials in filament or mat woven form. Suitable fibrous materials include, fiberglass, nylon, orlon, cotton, aramid, graphite, boron, cellulose, polyethylene and polypropylene.

A varnish-impregnated substrate is dried at, for example, 80 °C to 200 °C, preferably 100 °C to 200 °C for 0.5 to 60 minutes, preferably 0.5 to 30 minutes to obtain half-cured epoxy based prepreg.

In the preparation of electrical laminates, one or more plies of the prepreg material are pressed together at a pressure of, e.g., 10 to 50 $Kg/cm^2$ for 0.5 to 3 hours while being heated at 130 °C to 180 °C in order to prepare a laminate therefrom. One or more layers of an electrically conductive material is employed as an outer layer of the laminate which can be one of the outer layers of the multiply prepreg materials which is pressed together under heat or the electrically conductive outer layer can be applied later by means of an adhesive. Also, if the electrical conductive layer is employed as one of the plies which is pressed together under heat, there can be, if desired, an adhesive layer placed between it and the prepreg material.

Suitable electrically conductive materials which can be employed herein include, for example the electrically conductive metals such as, aluminum, copper, gold, silver and platinum and the electrically conductive organic polymers such as polyacrylonitrile, which have been carbonated and any combination thereof.

The electrical laminates manufactured as described above can be preferably used as copper clad laminates and multi-layer printed circuit boards for electrical or electronics equipment.

Examples and Comparative Examples

The following examples are illustrative of the invention, but are not to be construed as to limiting the scope thereof in any manner.

Examples 1 to 6 - Preparation of Resin Compositions

A 2-litter glass flask equipped with a stirrer, cooling tube and nitrogen purge line, was charged with a DCPD epoxy resin, tetrabromobisphenol A, and optionally, a brominated epoxy resin or a multifunctional epoxy resin, at a ratio as indicated in Table 1. The kind of the epoxy components used, the phenolic component used and the catalyst used are also as shown in Table 1.

After the flask was purged with nitrogen, the reaction mixture was heated by a heating mantle to about 120 °C (between 70 °C and 170 °C) to dissolve each component. After the resins were dissolved, a 70 percent methanol solution containing 0.32 g of ethyltriphenylphosphonium acetate was added to the reaction mixture, and the reaction mixture was further heated. When the reaction temperature reached

160 °C, the heating mantle was taken out to cool the reaction mixture to 150 °C. The reaction was continued at a temperature of 150 °C for a period of 90 minutes. Thereafter, 533.33 g of methyl ethyl ketone (MEK) was added to the reaction mixture to cool it to room temperature.

Preparation of Laminating Varnish

A laminating varnish was prepared by mixing the epoxy resin solution as indicated in Table 1, a dicyandiamide solution (dicyandiamide/dimethylformamide/propylene glycol methyl ether = 3/15/15) and a 2-ethyl-4-methylimidazole solution (2-ethyl-4-methylimidazole/methyl ethyl ketone = 1/9) as curing agent at a ratio as indicated in Table 1. To the resultant mixture, when desired, methyl ethyl ketone was added to adjust its viscosity.

Table 1

| Kind of Resin | | Ex 1 | Ex. 2 | Ex. 3 | Ex. 4 | Ex. 5 | Ex. 6 | Comp. Ex. 1 |
|---|---|---|---|---|---|---|---|---|
| **DCPD Epoxy Resin A** | (parts) | | 64.90 | 55.81 | 53.00 | 51.62 | 33.85 | |
| | (weight, g) | | 1038.40 | 892.96 | 848.00 | 825.92 | 541.60 | |
| **DCPD Epoxy Resin B** | (parts) | 67.68 | | | | 12.90 | | |
| | (weight, g) | 1082.88 | | | | 206.40 | | |
| **Liquid Epoxy Resin C** | (parts) | | | | | | 33.85 | 63.44 |
| | (weight, g) | | | | | | 541.60 | 1015.04 |
| **Brominated Epoxy Resin D** | (parts) | | 14.10 | 15.50 | 17.00 | 10.42 | | |
| | (weight, g) | | 225.60 | 248.00 | 272.00 | 166.72 | | |
| **Novolac Epoxy Resin E** | (parts) | | | | 10.00 | | | |
| | (weight, g) | | | | 160.00 | | | |
| **Multifunctional Epoxy Resin F** | (parts) | | | 7.75 | | | | |
| | (weight, g) | | | 124.00 | | | | |
| **TBBA** | (parts) | 32.32 | 21.00 | 20.93 | 20.00 | 24.06 | 32.31 | 36.56 |
| | (weight, g) | 517.12 | 336.00 | 334.88 | 320.00 | 384.96 | 516.96 | 584.96 |
| **Methylethyl Ketone** | (parts) | 33.33 | 33.33 | 33.33 | 33.33 | 33.33 | 33.33 | 25.00 |
| | (weight, g) | 533.28 | 533.28 | 533.28 | 533.28 | 533.28 | 533.28 | 400.00 |
| **Epoxy Equivalent** | (parts) | 562 | 452 | 415 | 419 | 488 | 503 | 485 |
| **Viscosity (cst at 25°C)** | | 1208 | 1550 | 1315 | 2356 | 2670 | 848 | 2320 |
| **Non-Volatiles Content (wt. %)** | | 75.50 | 74.90 | 74.20 | 74.90 | 75.00 | 75.00 | 80.00 |
| **Hydrolyzable Chlorine (ppm)** | | 70 | 37 | | | | | |

Table 1 (continued)

| Kind of Resin | | Ex 1 | Ex. 2 | Ex. 3 | Ex. 4 | Ex. 5 | Ex. 6 | Comp. Ex. 1 |
|---|---|---|---|---|---|---|---|---|
| Epoxy Resin | (parts) | 132.45 | 133.51 | 134.77 | 133.51 | 133.33 | 133.33 | 125 |
| Solution | (weight, g) | 1324.50 | 1335.11 | 1347.71 | 1335.11 | 1333.33 | 1333.33 | 1250.00 |
| Dicyandiamide | (parts) | 2.49 | 3.10 | 3.38 | 3.34 | 2.87 | 2.79 | 2.89 |
| | (weight, g) | 274 | 341 | 371 | 368 | 316 | 306 | 317.90 |
| Catalyst | (parts) | 0.20 | 0.20 | 0.20 | 0.20 | 0.20 | 0.20 | 0.20 |
| <2E4MZ> | (weight, g) | 20.00 | 20.00 | 20.00 | 20.00 | 20.00 | 20.00 | 20.00 |
| Methylethyl Ketone | (parts) | 15.18 | 8.49 | 4.66 | 6.22 | 10.79 | 11.58 | 18.95 |
| | (weight, g) | 151.76 | 84.86 | 46.62 | 62.21 | 107.86 | 115.80 | 189.51 |

Note: Epoxy Resin A is a polyglycidyl ether of a phenol-dicyclopentadiene resin (EEW:250; Average Functionality: 3.2).

Epoxy Resin B is a polyglycidyl ether of a phenol-dicyclopentadiene resin (EEW:230; Average Functionality: 2.2).

Epoxy Resin C is a glycidyl ether of bisphenol A (D.E.R.™ 331L; EEW:185).

Epoxy Resin D is a glycidyl ether of tetrabromobisphenol A (D.E.R.™ 542; EEW:330).

Epoxy Resin E is a polyglycidyl ether of a phenol-formaldehyde novolac resin (QUATREX™ 3410; EEW:199; Average Functionality: 7.0).

Epoxy Resin F is a polyglycidyl ether of a tris(hydroxylphenyl)methane novolac resin (TACTIX™ 742; EEW:160; Average Functionality: 3.0).

TBBA is tetrabromobisphenol A (Hydroxyl Equivalent: 272; Bromine Content: 58.8%).

D.E.R, QUATREX, and TACTIX are trademarks of The Dow Chemical Company.

The gel time (reactivity) of the varnish obtained was measured by placing the varnish on a hot plate heated to 175 °C, and then measuring stroke curing time. The glass transition temperature of the resins obtained was measured by a du Pont Instrument 1090 thermal analyzer comprising a Differential Scanning Calorimeter (DSC) and a thermal mechanical analyzer (TMA), at a temperature rise rate of 10 °C/min. The results are as shown in Table 2.

Preparation of Prepreg

Strips (21 cm X 24 cm) of glass cloth (7628 Type; No. 7628AS450; Manufactured by Asahi Shuebel) were manually impregnated into the varnish obtained. After impregnation, the thus impregnated strips were subjected to heat treatment in an oven heated to 165°C for 90 to 135 seconds, to obtain prepreg. In addition, the heating time (residence time in an oven) was determined by measuring the degree of cure of the prepreg by placing it on a hot plate heated to 175°C so as to set the gel time within a range of 60 to 120 seconds.

Preparation of Laminate

The prepreg obtained under the above conditions was cut into strips having a width of 21 cm and a length of 18 cm. Eight strips of the cut prepreg were laminated, and pressed while being heated for 90 minutes. The heat-press treatment was conducted such that the final temperature was 175°C and the final press pressure was 35 $Kg/cm^2$. In addition, in some cases, a copper foil having a thickness of 35 micron meters was simultaneously laminated with the cut prepreg to measure copper peel strength.

The physical properties of the cured products were evaluated in the following manner.

Moisture Resistance

The laminates obtained were cut into small pieces (5 cm X 5 cm), and subjected to pressure cooker test in a steam saturated atmosphere, at a temperature of 121°C, at a pressure of 2 atoms for a period of 2 hours. The moisture resistance was evaluated using the following index:

$$\frac{\text{Water Pickup of Laminate After Treatment}}{\text{Water Pickup of Laminate Before Treatment}} \times 100\ (\%).$$

Heat Resistance (Solder Resistance)

After completing the pressure cooker test, solder resistance was measured by dipping three laminates for each Examples into solder heated to 260°C for 20 minutes, and then observing the surface of the treated laminates whether swelling or coming off can be seen on the laminate surface.

Adhesiveness (Copper Peel Strength)

The copper peel strength was measured in accordance with JIS C-6481.

The results of the testing are as shown in Table 2.

Comparative Example

The procedures of Example 1 were repeated except that a resin solution comprising a liquid epoxy resin alone was used as epoxy component as indicated in Table 1. The results are as shown in Table 2.

Table 2

| Kind of Resin | Ex. 1 | Ex. 2 | Ex. 3 | Ex. 4 | Ex. 5 | Ex. 6 | Comp. Ex. 1 |
|---|---|---|---|---|---|---|---|
| Reactivity (sec at 175°C) | 190 | 115 | 127 | 109 | 134 | 205 | 175 |
| Glass Transition Temperature <DSC> (°C) | 145 | 175 | 180 | 182 | 176 | 157 | 128 |
| Glass Transition Temperature <TMA> (°C) | 144 | 170 | 175 | 176 | 163 | 151 | 119 |
| Water Pick Up <Pressure Cooker Test> (121°C, 2 atom, 2 hrs) | 0.207 | 0.240 | 0.286 | 0.281 | 0.218 | 0.213 | 0.470 |
| Solder Resistance) 260°C, 20 sec.) | 88 | 68 | 18 | 25 | 56 | 30 | 0 |

## Claims

**1.** An epoxy resin composition comprising:

(A) a dicyclopentadiene-novolac epoxy resin represented by the following formula (I):

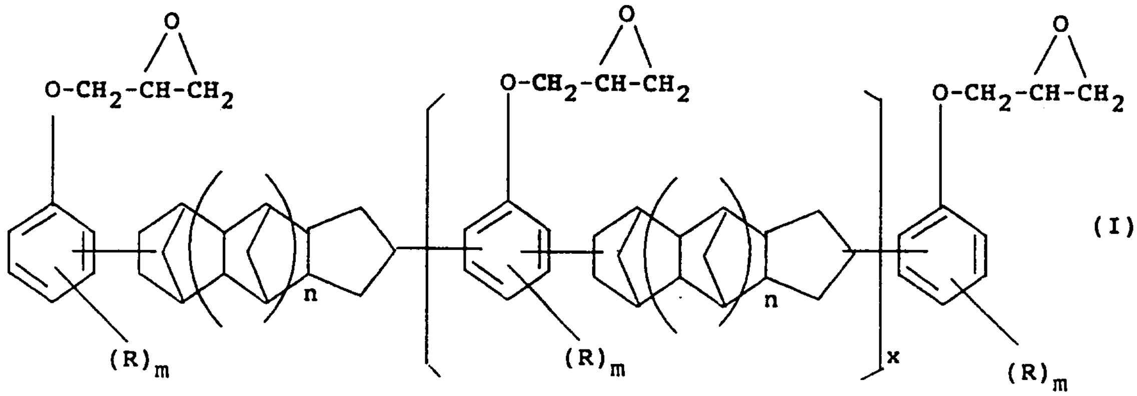

(I)

wherein each R is independently a hydrogen atom, an alkyl group having 1 to 3 carbon atoms or a halogen group; n is a number of from 0 to 2; m is a number of from 0 to 4; and x is a number of from 0 to 6; and

(B) at least one phenolic hydroxyl-containing compound.

**2.** An epoxy resin composition according to Claim 1, which further comprises:

(C) an epoxy-containing component, which is different from Component (A), selected from (C-1) an epoxy resin having an average of not more than 2 vicinal epoxy groups, (C-2) an epoxy resin having an average of more than 2 vicinal epoxy groups, and (C-3) a combination of Component (C-1) and Component (C-2).

**3.** An epoxy resin composition according to Claim 2, wherein Component (C-1) is a glycidyl ether of bisphenol A, bisphenol K, bisphenol F, bisphenol S, bisphenol AD, a brominated derivative thereof or a mixture thereof.

**4.** An epoxy resin composition according to Claim 2, wherein Component (C-2) is a phenol-formaldehyde novolac epoxy resin, a cresol-formaldehyde novolac epoxy resin, a brominated phenol-formaldehyde novolac epoxy resin, a brominated cresol-formaldehyde novolac epoxy resin or a mixture thereof.

**5.** An epoxy resin composition according to Claim 1, wherein Component (B) is bisphenol A, bisphenol K, bisphenol F, bisphenol S, bisphenol AD, a brominated derivative thereof or a mixture thereof.

**6.** An epoxy resin composition according to Claim 1, wherein Component (B) is a phenol-formaldehyde novolac resin, a cresol-formaldehyde novolac resin, a brominated phenol-formaldehyde novolac resin, a brominated cresol-formaldehyde novolac resin or a mixture thereof.

**7.** An epoxy resin composition according to Claim 1, which further comprises an amine curing agent selected from dicyandiamide, bis(4-aminophenyl)sulfone, aminophenylsulfoneamide, phenylenediamine, methylenediamine and a mixture thereof.

**8.** An epoxy resin composition according to Claim 1, wherein the epoxy component and the phenolic hydroxyl component are present to provide an epoxy component to phenolic hydroxyl component ratio by weight of from 60:40 to 80:20.

**9.** A laminating varnish comprising an epoxy resin composition according to Claim 1, and at least one solvent.

**10.** A laminating varnish according to Claim 9, wherein the solvent is acetone, methyl ethyl ketone, methanol, ethanol, propylene glycol methyl ether, dimethylformamide or a mixture thereof.

**11.** An electrical laminate resulting from curing one or more plies of a substrate material which has been impregnated with a laminating varnish of Claim 10.

**12.** A process for preparing an electrical laminate which comprises the steps of (a) impregnating a substrate with an epoxy resin composition of Claim 1; (b) heating the thus prepared prepreg; (c) fabricating the prepreg into an electrical laminate by laminating one or more layers of the prepreg with an electrical conductive material; and (d) heating the thus prepared laminate at elevated temperature and pressure.

European Patent Office

# EUROPEAN SEARCH REPORT

Application Number

EP 92 10 2764

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | EP-A-0 393 472 (BASF AKTIENGESELLSCHAFT)<br>* claims; examples *<br>--- | 1-12 | C08G59/06<br>C08J5/24 |
| X | EP-A-0 232 910 (THE DOW CHEMICAL COMPANY)<br>* claims *<br>--- | 1-12 | |
| X | US-A-4 394 497 (THE DOW CHEMICAL COMPANY)<br>* column 3, line 49 - line 57; claims *<br>--- | 1-12 | |
| A | US-A-4 710 429 (THE DOW CHEMICAL COMPANY)<br>* claims *<br>----- | 1 | |
| | | | TECHNICAL FIELDS SEARCHED (Int. Cl.5 ) |
| | | | C08G<br>C08J |

The present search report has been drawn up for all claims

| Place of search | Date of completion of the search | Examiner |
|---|---|---|
| THE HAGUE | 29 OCTOBER 1992 | DERAEDT G. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P0401)